# EUROPEAN PATENT APPLICATION

(11) **EP 4 765 201 A1**
(43) Date of publication of application: **24.06.2026**
(21) Application number: 24220966.6
(22) Date of filing: 18.12.2024
(51) Int. Cl.: H01L 23/40, H01L 23/00

(54) **SHRINK FITTED ELECTRONIC DEVICE**

(71) Applicant: Siemens Aktiengesellschaft, 80333 München (DE)
(72) Inventor: Grundmann, Jörn, 91091 Großenseebach (DE); Kriegel, Kai, 81739 München (DE); Madkour, Sherif, 12159 Berlin (DE); Mitic, Gerhard, 81827 München (DE); Schwarz, Florian, 91466 Gerhardshofen (DE); Stegmeier, Stefan, 81825 München (DE); Walbrecker-Baar, Christian, 85757 Karlsfeld (DE)
(74) Representative: Siemens Patent Attorneys

(57) **Abstract**

The invention relates to assembly and disassembly of electronic devices, e.g. power modules or MEMS modules. In that context, the invention is situated at the intersection of advanced assembly of electronic devices and environmental sustainability. It addresses the critical need for Robust Eco-Design (RED) with design in the 7R setting. For that purpose, the invention foresees to equip components of the electronic device which are to be fixed to each other, e.g. a heat sink, a substrate, and a semiconductor chip, with interlocking arrangements which can be securely fixed to each other with a shrink fitting procedure. This allows, on the one hand, stable fixation of the components and, on the other hand, simple separation of the components for the purpose of disassembling the electronic device.

## Description

The invention relates to assembly and disassembly of electronic devices. In that context, the invention is situated at the intersection of advanced assembly of electronic devices and environmental sustainability. It addresses the critical need for Robust Eco-Design (RED) with design in the 7R setting (Reduce, Reliability, Reuse, Repair, Refurbishment, Remanufacturing, and Recycling) to save resources and to reduce environmental impact.

Electronics in general and, specifically, power electronics in power modules often have a stack build-up where components of the electronic device are bonded together through soldering and/or sintering. The use of soldering or sintering poses significant barriers to the disassembly of the component stacks and consequently impacts the 7R qualification of the electronic device. The nature of the stack's bonds being permanent requires complex, costly, and environmentally taxing processes to disassemble, leading to inefficient recycling and reuse practices.

In addition, RED solutions should also be integrable into electronics and power electronics manufacturing processes currently available to reduce the barrier for implementation and initial capital expenditure needed.

To date, the challenges associated with the disassembly of stacked components in electronics and power electronics at end-of-first life or end-of-life or during repair processes, particularly those related to soldering/sintering techniques and the high copper content, have been approached through various methods:
Regarding "Advanced Soldering and Sintering Techniques", innovations in soldering and sintering processes have been developed to facilitate easier disassembly. These include the use of different solders and sintering materials, although they often still require complex and costly procedures for effective separation.

In the context of "Mechanical and Thermal Disassembly Methods", mechanical methods, such as shredding and crushing, and thermal processes, such as pyrolysis, have been employed to separate components in power modules. However, these methods are energy-intensive, destructive and might be even environmentally taxing.

The approach of "Chemical Treatment Processes" utilizes chemical methods, involving solvents or other chemical agents to dissolve or weaken bonds, to disassemble power modules. These processes, while effective in certain contexts, often raise environmental and safety concerns due to the use of hazardous chemicals.

Finally, regarding "Recycling and Material Recovery Techniques", recycling methods, specifically tailored to recover copper and other valuable materials from power modules, have been implemented. These techniques, including hydrometallurgical and electrometallurgical processes, focus on material recovery but do not necessarily simplify the disassembly process.

While these existing solutions represent significant efforts to address the identified challenges, they often involve trade-offs between effectiveness, cost, environmental impact, and practicality. The approaches reveal a notable gap in achieving a comprehensive and environmentally sustainable solution for the disassembly of power modules, especially in terms of fully integrating design for recyclability and Eco-Design strategies. This gap underscores the need for continued innovation and development in this field.

Thus, an assembly-disassembly strategy integrated in the design of the assembly is required that can even be realized with current manufacturing equipment with minimal modification which can accelerate the adoption of the electronics and power electronics.

Therefore, a solution is required which enables assembly and disassembly of electronic devices with special focus on 3R or 7R eligibility. This is solved by the methods of claims 1 and 10 and a device according to claim 12.

A method METH_CR_FIX(INTER) foresees to connect a first COM1 and a second component COM2 of an electronic device with each other at an interface INTER by securely fixing a first interlocking arrangement ARR1 of the first component COM1 to a second interlocking arrangement ARR2 of the second component COM2 with the help of applying different temperature scenarios such that, on the one hand, the interlocking arrangements ARR1, ARR2 of the components COM1, COM2 and, therewith, the components COM1, COM2 themselves are securely fixed to each other under a second one of the temperature scenarios and, on the other hand, the interlocking arrangements ARR1, ARR2 of the components COM1, COM2 are attachable to each other and, in case previously securely fixed to each other, non-destructively separable from each other and under a first one of the temperature scenarios. Therein, the method METH_CR_FIX(INTER) applies a shrink fitting procedure to connect the first COM1 and the second component COM2.

The interface INTER can actually comprise the interlocking arrangements ARR1, ARR2, wherein the first temperature scenario is characterized in that either a temperature differential dT across the interface INTER and, therewith, between the interlocking arrangements ARR1, ARR2 is above a given threshold or that the temperature of the interface INTER, i.e. the temperature in the immediate surrounding of the interface INTER, and its interlocking arrangements ARR1, ARR2, respectively, is outside a given regular operation temperature range TR of the electronic device. The second, regular temperature scenario is characterized in that either the temperature differential dT across the interface INTER and, therewith, between the interlocking arrangements ARR1, ARR2 is below a given threshold or that the temperature of the interface INTER and its interlocking arrangements ARR1, ARR2, respectively, is within the given regular temperature range TR of the electronic device during regular operation of the device.

Therein, the regular operation temperature range TR is the typical temperature range which applies during regular operation of the device. Moreover, the formulation "temperature differential dT across the interface" builds on that the temperature differential dT is the difference of the temperatures of first and second interlocking arrangement ARR1, ARR2 of the interface INTER. However, this is not defined sharply, but a skilled person will be clear which conditions are required to apply the shrink fitting procedure for connecting the arrangements ARR1, ARR2.

The interlocking arrangement ARR1 of the first component COM1 and an interlocking arrangement ARR2 of the second component COM2 might be created in a creation procedure PROC_CR(INTER) of the method METH_CR_FIX(INTER) at respective surfaces SURF1, SURF2 of the components COM1, COM2 such that the interlocking arrangements ARR1, ARR2 are adapted to each other for the purpose of connecting the components COM1, COM2 with each other with the shrink fitting procedure.

Herein and in the following, the expression that two arrangements ARR1, ARR2 are "adapted to each other" means that the concerned arrangements ARR1, ARR2 are suitable for the shrink fitting procedure.

The creation procedure PROC_CR(INTER) might comprise a first step CR1(INTER) of selecting geometries of the interlocking arrangements ARR1 and ARR2 suitable for the shrink fitting procedure such that the arrangements ARR1 and ARR2 are adapted to each other. For example, one suitable geometry might be such that one interlocking arrangement ARR1 is formed from grooves while the other interlocking arrangement ARR2 is formed from corresponding ridges. A second step CR2(INTER) of the procedure PROC_CR(INTER) might include to employ a computational modelling for dimensioning, designing and design optimization of the interlocking arrangements ARR1 and ARR2 based on the selected geometries and/or for selecting best suited materials for the interlocking arrangements ARR1 and ARR2. For example, this step CR2(INTER) defines concrete dimensions and extensions of the arrangements ARR1, ARR2, e.g. in case the interlocking arrangements are ridges and grooves, the depths, widths, and angles of the grooves and ridges, as well as the best suited materials. The modelling might focus on enhancing thermal expansion compatibility and mechanical stability under operational loads, such as tensile and shear forces, and ensures enhanced thermal contact by optimizing interfacial pressure and surface characteristics. Thus, the arrangements ARR1, AR2 are designed, depending on the particular field of application, to optimize mechanical stability and especially enhanced thermal contact. Thus, the arrangements ARR1, AR2 are designed, depending on the particular field of application, to optimize mechanical stability and especially enhanced thermal contact. In a third step CR3(INTER) of the procedure PROC_CR(INTER), the computationally modeled interlocking arrangements ARR1, ARR2 are produced, i.e. indeed manufactured or fabricated, respectively, at the respective surfaces COM1_SURF, COM2_SURF of the components COM1, COM2.

As a result of execution of steps CR1 and CR2, the interlocking arrangements ARR1, ARR2 are optimally adapted to each other. Subsequent execution of step CR3, i.e. the whole of CR1, CR2, and CR3, results in the interlocking arrangements ARR1 at the surface COM1_SURF of component COM1 and ARR2 at the surface COM2_SUFR of component COM2.

The interlocking arrangements ARR1, ARR2 of the components COM1, COM2 and, therewith, the components COM1, COM2 themselves, might then be securely fixed to each other in a fixation procedure PROC_FIX(INTER) of the method METH_CR_FIX(INTER) for the purpose of connecting the components COM1, COM2 with each other with the shrink fitting procedure.

The fixation procedure PROC_FIX(INTER) might comprise a first step FIX1(INTER) of changing the temperature of at least one of the interlocking arrangements ARR1, ARR2 such that the first temperature scenario is induced, such that the arrangements ARR1, ARR2 undergo different thermal expansions, a second step FIX2(INTER) of connecting the components COM1, COM2 with each other by putting their interlocking arrangements ARR1, ARR2 together such that they interlock, for example, the ridges are positioned in the grooves which is possible due to the altered thermal expansions of step FIX1, and a third step FIX3(INTER) of actively or passively changing the temperature of at least one of the interlocking arrangements ARR1, ARR2 such that the second, regular temperature scenario is induced.

Preferably, a comprehensive documentation DOCASS(INTER) about the applied parameters of the creation procedure PROC_CR(INTER) and the fixation procedure PROC_FIX(INTER) is generated, wherein the documentation DOCASS(INTER) and the parameters, respectively, includes information required for later separation of the components COM1, COM2 for disassembly of the electronic device. This helps to determine the appropriate forces and directions for disengagement without causing structural damage so that disassembly results in separated components which can be further used.

For example, the electronic device can be a MEMS module comprising a MEMS as the first component COM1=MEMS and a printed circuit board PCB as the second component COM2=PCB.

In another example, the electronic device can be a power electronic module comprising a heat sink HS, a substrate SUB, and a semiconductor chip SC, wherein the substrate SUB is the first component COM1=SUB and the heat sink HS is the second component COM2=HS and/or the substrate SUB is the first component COM1=SUB and the semiconductor chip SC is the second component COM2=SC.

A disassembly method METH_DISASS(INTER) for separating components COM1, COM2 of an electric device which have been securely fixed to each other at the interface INTER based on a shrink fitting procedure, preferably based on the method METH_CR_FIX(INTER) described above, includes a first step DIS1(INTER) in which the first temperature scenario is induced at the interface INTER and a second step DIS2(INTER) in which the components COM1, COM2 are separated from each other once the conditions conducive to disengagement of COM1 and COM2 are established.

Therein, the required temperature generated under the first temperature scenario in step DIS1(INTER) and/or the required forces and directions for separating the components COM1, COM2 without causing structural damage might be set based on the documentation DOCASS(INTER) of the method METH_CR_FIX(INTER).

An electronic device, manufactured or assembled, respectively, based on the method METH_CR_FIX(INTER), comprises at least two components COM1, COM2, wherein each one of the components COM1, COM2 comprises at least one interlocking arrangement ARR1, ARR2, and wherein the components COM1, COM2 are securely fixed to each other with the help of their interlocking arrangements ARR1, ARR2 based on the shrink fitting procedure when the electronic device is in the assembled state.

The electronic device can be a MEMS module comprising a MEMS and a printed circuit board PCB, wherein the MEMS and the printed circuit board PCB are securely fixed to each other at the interface INTER based on the shrink fitting procedure when the MEMS module is in the assembled state. To achieve that, the method METH_CR_FIX(INTER) might have been executed for securely fixing the MEMS as the first component COM1=MEMS and the printed circuit board PCB as the second component COM2=PCB with each other at the interface INTER=INTER(MEMS,PCB) of the MEMS module.

The electronic device can also be a power module comprising a heat sink HS, a substrate SUB, and a semiconductor chip SC, wherein both the heat sink HS and the semiconductor chip SC are each securely fixed to the substrate SUB based on the shrink fitting procedure such that the substrate SUB is arranged between the heat sink HS and the semiconductor SC when the power module is in the assembled state. To achieve that, the method METH_CR_FIX(INTER1) might have been executed for securely fixing the substrate SUB=COM1 as the first component COM1 and the heat sink HS=COM2 as the second component COM2 with each other at an interface INTER1=INTER1(SUB,HS) of the power module and/or the method METH_CR_FIX(INTER2) might have been executed for securely fixing the substrate SUB=COM1 as the first component COM1 and the semiconductor chip SC=COM2 as the second component COM2 with each other at an interface INTER2=INTER2(SUB,SC) of the power module.

The invention distinguishes from known solutions in the field of assembly and disassembly of stacked components in electronics and power electronics through its unique approach, focusing on precision, environmental sustainability, and reusability. Key differences and advantages over the prior art are as follows:

Existing solutions rely on advanced soldering and sintering techniques, which still necessitate complex procedures. The invention employs an innovative design of interlocking structures, such as groove-ridge-combinations, dovetail joints, or wave-like patterns, optimized through computational modelling for thermal expansion and mechanical stability. This design approach facilitates easier assembly and disassembly without the need for (de-)soldering or (de-)sintering, leading to a more straightforward and potentially less costly process.

Precision Manufacturing Techniques vs. Mechanical/Thermal Methods: Traditional mechanical and thermal disassembly methods, like shredding or pyrolysis, often degrade the integrity of recoverable materials. The proposed invention is qualified to apply advanced manufacturing techniques, such as cold embossing, 3D printing, and CNC machining, to create precise interlocking structures. To enable automation, fiducial markers such as QR codes or geometric markers are integrated into the surface of components. These markers facilitate precise alignment and positioning during assembly and disassembly, allowing robotic systems to identify and handle components with high accuracy. This precision ensures the integrity of materials is maintained, allowing for better recyclability and less environmental impact.

The proposed procedures ensure a secure fit during assembly and an effective, safe separation during disassembly. As power modules heat up during operation, the pressure contacts between the interlocking structures increase due to metal expansion and thus higher reliability and durability.

Furthermore, direct contact of metal/metal is the best possible contact for heat conductivity. At operational temperatures, improvement in the thermal management of the whole system is to be expected and thus higher overall efficiency of the device.

While conventional recycling methods focus on material recovery after disassembly, often not addressing the disassembly process itself, this invention integrates Design for 7R and Eco-Design strategies. The interlocking structures are designed not only for effective disassembly but also for potential reassembly or recycling, enhancing the overall sustainability of the process.

The invention reduces environmental impact by avoiding the use of hazardous chemicals and preserving the integrity of materials, enabling more efficient recycling. The precision manufacturing and temperature differential methods also present a cost-effective solution compared to the complex, CapEx- and energy-intensive methods (e.g. sintering, soldering) in current practice.

Further resource saving could be expected. In the case of Power Modules, the elimination of copper baseplate, soldering or sintering paste and/or preforms is to be expected.

In summary, the proposed invention stands out from known solutions by offering precision interlocking structures, Eco-Design integration, advanced manufacturing techniques, thermal stress mitigation, and ease of disassembly. These differences result in advantages such as improved reliability, sustainability, and operational efficiency compared to existing assembly methods for power modules.

It is to be understood that the elements and features recited in the appended claims may be combined in different ways to produce new claims that likewise fall within the scope of the present invention. Thus, whereas the dependent claims appended below depend from only a single independent or dependent claim, it is to be understood that these dependent claims can, alternatively, be made to depend in the alternative from any preceding or following claim, whether independent or dependent, and that such new combinations are to be understood as forming a part of the present specification.

### DESCRIPTION OF THE FIGURES

In the following, possible embodiments of the different aspects of the present invention are described in more detail with reference to the enclosed figures. The objects as well as further advantages of the present embodiments will become more apparent and readily appreciated from the following description of the preferred embodiments, taken in conjunction with the accompanying figure in which:
- FIG 1: shows separated components of an electronic device,
- FIG 2: shows the device with the components put together,
- FIG 3: shows the device with securely fixed,
- FIG 4: shows a creation procedure,
- FIG 5: shows a fixation procedure,
- FIG 6: shows a method for connecting the components,
- FIG 7: shows a method for separating the components,
- FIG 8: shows separated components of a power electronics module,
- FIG 9: shows the power electronics module with its components put together,
- FIG 10: shows the power electronics module with its components securely fixed with to each other.

### DETAILED DESCRIPTION

The invention proposes a process chain for shrink fitting based assembly or disassembly of stacked components COM1, COM2, COM3, ... of an electronic device, e.g. in the field of power modules or mounting Microelectromechanical systems (MEMS) sensors, using manufacturing techniques to create precision-fit structures. These structures are designed to ensure optimal interlocking and thermal stress management.

In general terms, the shrink fitting procedure, which can be considered a known process, foresees to connect two components COM1, COM2 to one another so that they are securely fixed with each other, especially under regular working conditions of a device comprising those components COM1, COM2. The fixation of the components COM1, COM2 to one another is achieved with the help of respective interlocking arrangements ARR1, ARR2 of the components COM1, COM2 to be connected to each other via the shrink fitting procedure, wherein the interlocking arrangements ARR1, ARR2 form an interface INTER(COM1, COM2) of the components COM1, COM2. In this context, "regular working conditions" especially refers to the temperature during regular operation of the device. Under normal working conditions, the temperature Ts is in a certain known regular temperature range TR between a first temperature T1 and a second temperature T2. However, under normal working conditions, the arrangements ARR1, ARR2 cannot be put together due to their spatial extensions.

In relation to differences between manufacturing and application, the parameter "temperature" is the most important one. In pure reference to manufacturing, parameters such as fit, tolerance, and Young's modulus are also important. However, beyond temperature T, additional parameters influencing the shrink fitting procedure as such include material properties such as the coefficient of thermal expansion, thermal conductivity, and fatigue resistance, as well as dimensional tolerances and surface roughness of the interlocking arrangements. Environmental conditions, including humidity, contamination, and operational vibrations, along with load-bearing capacities such as shear and tensile strength, further influence the reliability and performance of the interlocking connection.

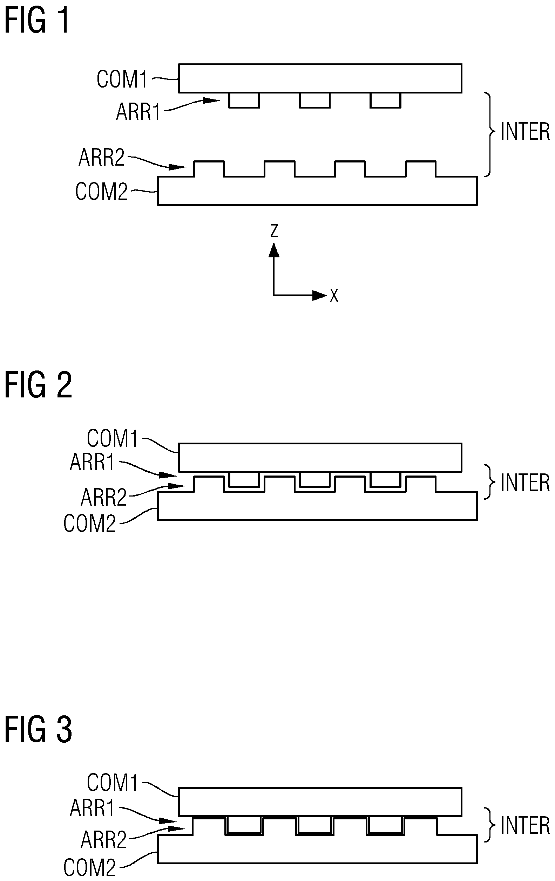

In a first step of the shrink fitting procedure, with the arrangements ARR1, ARR2 still being separate from each other as shown in FIG 1, a first temperature scenario is induced. The first temperature scenario is characterized in that a temperature differential dT across the interface INTER and across the interlocking arrangements ARR1, ARR2 is above a given threshold, such that the interlocking arrangements ARR1, ARR2 are facing significantly different temperatures, or the general temperature of the interface INTER, i.e. the temperature Ts in the surroundings of the interface INTER, is outside the given regular operation temperature range TR of the electronic device. In the latter case, the temperature Ts should be selected such that the different interlocking arrangements ARR1 and ARR2 undergo different thermal expansions.

For example, the first temperature scenario can be achieved by heating up or cooling down at least one of the arrangements ARR1, ARR2 so that their respective extensions change due to thermal expansion so that it becomes possible to put the arrangements ARR1, ARR2 together, as shown in FIG 2. In other words, the heating up or cooling down results in a temperature differential dT across the interface INTER, i.e. between the components COM1, COM2 or, more exactly, between the arrangements ARR1, ARR2, such that the arrangements can be put together.

Having done that, measures are taken so that a second temperature scenario applies. In contrast to the first temperature scenario, the second, regular temperature scenario is characterized in that the temperature differential dT across the interface INTER is below the given threshold or, as the case may be, the temperature Ts of the interface INTER is within the given regular temperature range TR of the electronic device. The respective measures might be passive measures, simply allowing the temperatures to develop so that the second scenario is achieved, or they might be active measures of cooling or heating up where necessary. However, the circumstance that the first temperature scenario applies results in respective thermal extension of the interlocked interlocking arrangements ARR1, ARR2 so that a strong mechanical bond of the arrangements ARR1, ARR2 is achieved and, therewith, the secure fixation of the components COM1, COM2, as shown in FIG 3.

The shrink fitting procedure offers the big advantage that the strong bond can be undone by applying the same change in temperature so that the same change of extension occurs and the arrangements ARR1, ARR2 can be separated again without more ado. Correspondingly, while the expression "securely fixed" used herein indeed means that the concerned components cannot be moved with respect to each other as long as the temperature is within the regular temperature range TR, being "securely fixed" still allows that the concerned components can be separated, as soon as the temperature leaves the regular temperature range TR or the temperature differential falls under the given threshold. This possibility to loosen the secure connection again allows to fulfill 7R and 3R requirements. More concrete and as outlined below, it depends on a temperature differential dT(COM1,COM2) between the concerned securely fixed components COM1, COM2 and their interlocking arrangements ARR1, ARR2, respectively, whether the components COM1, COM2 can be separated from each other or not.

A demand that arrangements ARR1, ARR2 should be "adapted to each other" and "suitable for a shrink fitting procedure", respectively, as required below means that, on the one hand, they cannot be put together under normal working conditions due to their extension and geometry. On the other hand, their geometries and their coefficients of thermal expansion are such that they can be put together at a temperature outside the regular temperature range TR and they are securely fixed to each other as soon as the temperature returns to the regular temperature range TR. In other words and in more general terms, two arrangements ARR1, ARR2 are suitable for a shrink fitting procedure in case such a shrink fitting procedure can be successfully applied to fix those arrangements ARR1, ARR2 to one another and to separate them again, if required. On the one hand, the suitability depends on the materials of the arrangements ARR1, ARR2 because the shrink fitting procedure depends on the material dependent coefficient of thermal expansion. On the other hand, the suitability depends on the geometry of the concerned arrangements ARR1, ARR2. In short, the suitability for shrink fitting depends on geometry and material parameters of the concerned interlocking arrangements ARR1, ARR2 which together form an interface INTER.

For example, ARR1 might have the form of an eyelet, so that ARR2 should have the form of a pin or protrusion which fits into the eyelet when the temperature is outside the regular temperature range TR. In another example, as included in FIGs 1-3, the first arrangement ARR1 comprises a number of parallel ridges RD with rectangular cross-section, extending in y-direction along the surface COM1_SURF. Correspondingly, the second arrangement ARR2 comprises a number of parallel grooves GR with rectangular cross-section extending in y-direction (perpendicular to x and z) along the surface COM2_SURF into which the ridges of the first arrangement ARR1 can be placed when the temperature Ts is outside the regular range TR or when a temperature differential dT is above a given threshold. In further examples, the arrangements ARR1, ARR2 might be adapted to each other to form a dovetail joint or a wave-like pattern.

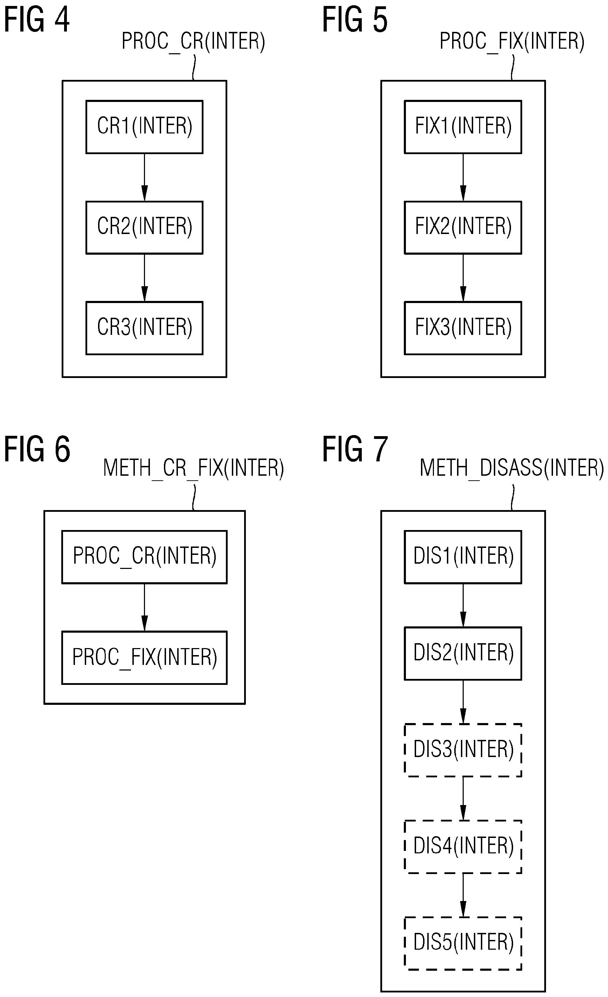

FIG 4 shows a creation procedure PROC_CR for creating interlocking arrangements ARR1, ARR2 optimally adapted to each other for the purpose of fixing the respective components COM1, COM2 to each other at the interface INTER(COM1 ,COM2). Here and in the following, the expression that two arrangements ARR1, ARR2 are "adapted to each other" means that the concerned arrangements ARR1, ARR2 are suitable for a shrink fitting procedure, as described herein.

A first procedure step CR1(INTER) of the creation procedure PROC_CR(INTER) includes the selection of suitable geometries of the interlocking arrangements ARR1 and ARR2. As mentioned above, one suitable geometry might be such that one interlocking arrangement ARR1 is formed from grooves while the other interlocking arrangement ARR2 is formed from corresponding ridges. Another suitable geometry might be such that the arrangements ARR1 and ARR2 form a dovetail joint.

In a second procedure step CR2(INTER) of PROC_CR(INTER), a computational modelling is employed for design and subsequent design optimization of the interlocking arrangements ARR1 and ARR2. For example, this step CR2(INTER) defines concrete dimensions and extensions of the arrangements ARR1, ARR2, e.g. the depths and widths of the grooves and ridges, as well as the best suited materials. The material and its parameters has an influence through parameters such as CTE (Coefficient of Thermal Expansion), ductility, strength, and creep behavior. Furthermore, surface roughness also plays a role. The choice of materials of the interlocking arrangements must balance high thermal conductivity for efficient heat dissipation, e.g. copper or aluminum alloys, with mechanical stability and durability under operational loads. Surface properties, such as roughness and coatings, e.g. anti-corrosion or thermal interface coatings, are also considered to enhance contact reliability and reduce wear over time.

The modelling focuses on enhancing thermal expansion compatibility and mechanical stability under operational loads, such as tensile and shear forces, and ensures enhanced thermal contact by optimizing interfacial pressure and surface characteristics. Thus, the arrangements ARR1, AR2 should be designed, depending on the particular field of application, to optimize mechanical stability and especially enhanced thermal contact.

In a third step CR3(INTER) of PROC_CR(INTER), the therewith computationally modeled and planned interlocking arrangements ARR1, ARR2 are indeed created at the respective surfaces COM1_SURF, COM2_SURF of the components COM1, COM2.

Thus, the execution of the procedure steps CR1, CR2, CR3 results in interlocking arrangements ARR1 at the surface COM1_SURF of component COM1 and ARR2 at the surface COM2_SUFR of component COM2, wherein, as a consequence, these optimized interlocking arrangements ARR1, ARR2 are now adapted to each other.

Subsequently, the components COM1, COM2 can be fixed to each other at the interface INTER(COM1, COM2) in a fixation procedure PROC_FIX(INTER), illustrated in FIG 5.

In a first step FIX1(INTER) of the fixation procedure PROC_FIX(INTER), measures are taken to induce the first temperature scenario. I.e. the temperature in the surroundings of the interface INTER and, especially, of the arrangements ARR1, ARR2 is modified such that it is outside the regular temperature range TR or, as the case may be, a temperature differential dT(INTER) is created so that the arrangements ARR1, ARR2 are facing significantly different temperatures. For example, the temperatures of the arrangements ARR1, ARR2 are changed such that they are outside the regular temperature range TR of the components COM1, COM2 or, as the case may be, the first step FIX1(INTER) foresees to treat the arrangements ARR1, ARR2 differently so that they have different temperatures so that the temperature differential dT(INTER) across the concerned interlocking arrangements ARR1, ARR2 is induced. As a consequence of the temperature differential dT, the arrangements ARR1, ARR2 are exposed to different temperatures so that they undergo different thermal expansions.

In a second step FIX2(INTER) of PROC_FIX(INTER), the components COM1, COM2 are connected with each other by putting their arrangements ARR1, ARR2 together as required, i.e. such the arrangements ARR1, ARR2 interlock. Herein, a suitable assembly line or apparatus is utilized which achieves precise positioning of concerned components COM1, COM2 and, especially, interlocking arrangements ARR1, ARR2 with high accuracy. This ensures the correct alignment and placement essential for the procedure.

In a third step FIX3(INTER) of PROC_FIX(INTER), active or passive measures are taken to induce the second temperature scenario. I.e. the temperatures are allowed to return into the regular temperature range TR or, as the case may be, the temperature differential dT(INTER) is terminated. This temperature normalization allows for the establishment of contact pressure, culminating in a reliable and enduring connection between the concerned interlocking arrangements ARR1, ARR2, so that COM1 and COM2 are securely fixed to each other. If necessary, the arrangements ARR1, ARR2 might be held in the desired position until the temperature has returned to the regular temperature range TR. Active measures might include cooling or heating up of the concerned component COM1, COM2 while passive measures simply include to let the temperatures develop by themselves.

As a result of executing the procedure PROC_FIX(INTER), the components COM1, COM2 are securely fixed to each other at the interface INTER, resulting in a reliable and durable connection, essential for the long-term performance of the concerned electronic device.

The suggested methodological approach in design and assembly, realized by executing a method METH_CR_FIX(INTER) illustrated in FIG 6 including both the creation procedure PROC_CR(INTER) and subsequently the fixation procedure PROC_FIX(INTER), ensures not only the precise and stable integration of components COM1, COM2 at the interface INTER, but also addresses critical aspects such as thermal management and mechanical durability, which are pivotal in the efficient functioning of electronics and semiconductor devices. Preferably, the method METH_CR_FIX(INTER) includes a step DOCASS(INTER) of comprehensive documentation about the creation procedure PROC_CR(INTER) and the fixation procedure PROC_FIX(INTER). Such documentation DOCASS(INTER) should include all information required or helpful for later disassembly or separation of the components COM1, COM2 in a procedure PROC_DISASS(INTER). Such helpful information might include details about the interlocking structure formed from the interlocking arrangements ARR1, ARR2, e.g. being a groove-ridge-combination, a pin-eyelet-combination, a dovetail joint, or a wave-like pattern, details about the concerned materials of the interlocking arrangements ARR1, ARR2, details about the temperatures of the first and second temperature scenario, e.g. the applied temperature differential dT(INTER) etc. From the details about the interlocking structure, it can be concluded how the interlocking arrangements ARR1, ARR2 can be separated from each other, e.g. into which direction they can be moved relative to each other once the first temperature scenario is achieved.

The execution of the method METH_CR_FIX(INTER) with components COM1, COM2 results in that the first component COM1 and the second component COM2 are securely fixed to each other. However, as introduced above, despite the "secure" connection, it is still possible to separate the concerned components COM1, COM2 from each other, e.g. by re-establishing the first temperature scenario. In other words, the securely connected components COM1, COM2 are only inseparable as long as the second temperature scenario applies.

The method METH_CR_FIX(INTER) introduced above brings the advantage that an electronic device, which has been assembled using the method METH_CR_FIX(INTER), comprises, on the one hand, very stable connections between the device's components COM1, COM2. On the other hand, those connections can be easily loosened again because they are essentially of mechanical nature. Thus, induction of the first temperature scenario at the interface INTER again causes the thermal expansion or contraction of the concerned interlocking arrangements ARR1, ARR2 of the components COM1, COM2 as during assembly and execution of METH_CR_FIX(INTER), respectively. As a result, the concerned interlocking structure ARR12, being the interlocked and securely fixed first and second interlocking arrangement ARR1, ARR2, e.g. being a groove-ridge-combination, a pin-eyelet-combination, a dovetail joint, or a wave-like pattern, is effectively loosened so that the components COM1, COM2 can be separated from each other. The exact parameters of the first temperature scenario, e.g. the required temperature differential dT'(INTER), depend on the initial conditions of assembly and the thermal properties of the materials used. In the best case, they can be concluded from the documentation DOCASS(INTER).

A method METH_DISASS(INTER) for disassembling an electronic device 100 which has been assembled using the method METH_CR_FIX is shown in FIG 7. In a first method step DIS1 (INTER), the first temperature scenario is induced, e.g. a temperature differential dT'(INTER) across the interface INTER.

In a second step DIS2(INTER) of the method METH_DISASS(INTER), a controlled and gentle separation of the components COM1, COM2 of the interface INTER is executed once the conditions conducive to disengagement of COM1 and COM2 are established. This step DIS2(INTER) should be performed with care, ensuring no damage to the sophisticated interlocking structures, especially those crafted through precision techniques like CNC machining. Specialized disassembly equipment, such as pneumatically controlled clamping devices or automated separation tools equipped with force sensors, can be employed to ensure uniform and appropriate force distribution. For instance, automated thermal-grip systems can maintain precise temperature profiles during disassembly to prevent deformation of interlocking structures. These tools mitigate the risk of mechanical stress or misalignment, preserving the integrity of the components.

Where necessary, specialized disassembly equipment might be utilized to facilitate the separation process. These tools, e.g. like Apple's robot "Daisy", are designed to exert uniform and appropriate forces, mitigating the risk of damage to the components. The disassembly methodology should prioritize the preservation of the integrity of the interlocking structures and their interlocking arrangements ARR1, ARR2, respectively. This preservation is vital for potential reassembly or recycling of the components COM1, COM2.

In case the preservation of interlocking structures is not a primary concern, an alternative, more vigorous disassembly method may be utilized in the second step DIS2(INTER), focusing on the efficient recovery of core components such as the substrate SUB, the Microelectromechanical System (MEMS), or the semiconductor chip SC. This approach permits the expedited separation of these core components, foregoing the delicacy required for maintaining the integrity of interlocking structures and their interlocking arrangements ARR1, ARR2, respectively.

In an optional third step DIS3(INTER), which might be executed subsequent to the disassembly step DIS2(INTER), a specialized cleaning process can be implemented to remove any residual copper layers and Cu-sputtered structures, as the case may be, while preserving the fundamental value and functionality of the core components, thereby rendering them suitable for reuse or recycling.

In an optional fourth step DIS4(INTER), comprehensive disassembly documentation DOCDISASS(INTER) is generated which provides detailed procedural information about the disassembly process PROC_DISASS(INTER). This documentation DOCDISASS(INTER) might include any information required or helpful for further use of the separated components COM1, COM2. For example, the documentation DOCDISASS(INTER) might include applied specific temperature ranges, tool specifications like force limits or recommended disassembly tools, and techniques, alongside safety measures to protect against component damage and ensure operator safety. For example, specifying the temperature threshold for loosening the interlock or detailing the use of force-controlled robotic arms for disassembly ensures consistent and repeatable processes.

In an optional fifth step DIS5(INTER), further documentation DOCUSE(COM1), DOCUSE(COM2) is generated, outlining procedures for handling, storing, and possibly reassembling or recycling the separated components COM1. COM2. This might include instructions on maintaining the condition of the components COM1, COM2 and/or interlocking arrangements ARR1, ARR2.

The documentations DOCDISASS(INTER), DOCUSE(COM1), DOCUSE(COM2) generated in the fourth and fifth step might be combined to one joint documentation.

The procedure PROC_DISASS(INTER) for disassembling the electronic device 100, which has been assembled using the method METH_CR_FIX(INTER), at the interface INTER requires identification and analysis of the applied interlocking structure. Such information can be concluded from the documentation DOCASS(INTER). This helps to determine the appropriate forces and directions for disengagement without causing structural damage. By utilizing automated analysis tools and referencing procedural guidelines, operators can streamline disassembly processes while maintaining high precision and safety.

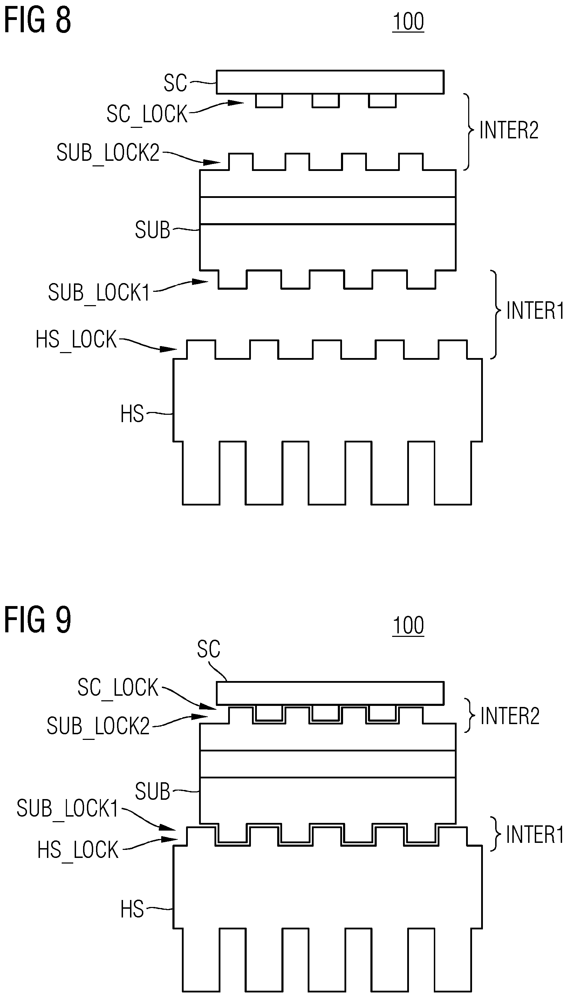

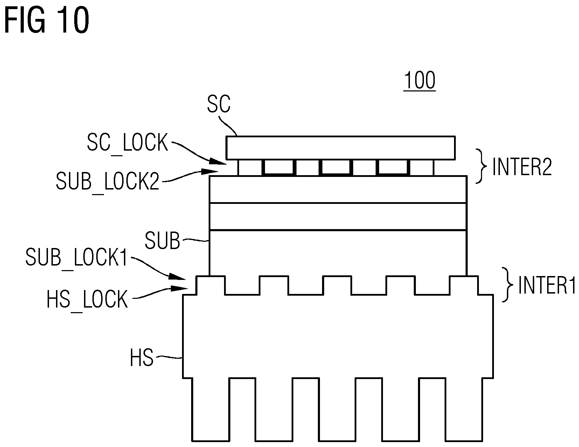

In a first concrete embodiment, the electronic device 100 is a power module PWR which essentially comprises a substrate SUB, a heat sink HS, and a semiconductor chip SC, as shown in FIGs 5-7. Therein, FIG 8 shows the components still separated from each other, FIG 9 shows the situation under the first temperature scenario when the components have just been put together, and FIG 10 shows the final status, i.e. the assembled power module now under the second temperature scenario with securely fixed components.

The substrate SUB might be, for example, a "Direct Copper Bonding" based substrate or an "Insulated Metal Substrate". As shown in FIG 10, these components SUB, HS, SC are connected to each other to form a stack with the substrate SUB being arranged between the heat sink HS and the chip SC. Thus, a first surface SUB_SURF1 of the substrate SUB is attached to a corresponding surface HS_SURF of the heat sink HS at a first interface INTER1=INTER1(SUB,HS) of the power module 100. A second surface SUB_SURF2 of the substrate SUB, being arranged at the substrate SUB oppositely to the first surface SUB_SURF1, is attached to a corresponding surface SC_SURF of the chip SC at a second interface INTER2=INTER2(SUB,SC) of the power module 100.

It is desired to securely fix the heat sink HS, the substrate SUB, and the semiconductor chip SC with each other, such that such fixation can be loosened again to address 7R and 3R requirements, as described above. For that purpose, each one of the substrate SUB, the heat sink HS, and the chip SC is equipped with an interlocking arrangement SUB_LOCK1, SUB_LOCK2, HS_LOCK, SC_LOCK as introduced above at its respective surface SUB_SURF1, SUB_SURF2, HS_SURF, SC_SURF. Therein, the substrate SUB has two interlocking arrangements SUB_LOCK1, SUB_LOCK2 as it shall be connected both to the heat sink HS and to the semiconductor chip SC.

In concrete, the interlocking arrangements SUB_LOCK1 and HS_LOCK form the first interface INTER1 and the interlocking arrangements SUB_LOCK2 and SC_LOCK form the second interface INTER2 of the power module 100. Thus, it is required that the interlocking arrangements SUB_LOCK1 and HS_LOCK of the first interface INTER1 are "adapted to each other" so that they are suitable for the shrink fitting procedure. The same applies for the interlocking arrangements SUB_LOCK2, SC_LOCK of the second interface INTER2. This requirement can be fulfilled by executing the procedure PROC_CR both for the first interface INTER1, i.e. for the interlocking arrangements ARR1=SUB_LOCK1 and ARR2=HS_LOCK, and for the second interface INTER2, i.e. for the interlocking arrangements ARR1=SUB_LOCK2 and ARR2=SC_LOCK.

For the first interface INTER1, at which the substrate SUB is connected to the heat sink HS, and for the adaption of its interlocking arrangements SUB_LOCK1 and HS_LOCK to each other, the first procedure step CR1(INTER1) of the creation procedure PROC_CR(INTER1) is executed, including the selection of suitable geometries of the interlocking arrangements SUB_LOCK1 and HS_LOCK, e.g. grooves and ridges, and suitable materials. For example, materials with complementary thermal expansion coefficients can be selected, such as copper for the substrate SUB and aluminum for the heat sink HS, while incorporating a graphene-based thermal interface material (TIM) in between to enhance thermal conductivity and accommodate expansion mismatches.

In the second step CR2(INTER1), a computational modelling is employed for design and subsequent design optimization of the interlocking arrangements SUB_LOCK1 and HS_LOCK, e.g. to determine, on the one hand, the depths, widths, and angles of the grooves and ridges, the density of the interlocking structures per surface area as well as optimal geometrical features of the grooves and ridges for thermal performance, and to determine, on the other hand, the best suited materials as introduced above. Step CR2(INTER1) might optionally foresee to incorporate a Thermal Interfacial Material (TIM) layer between the substrate SUB and the heat sink HS to improve contact reliability and accommodate thermal expansion discrepancies between different materials, e.g. in case the substrate SUB is copper based and the heat sink HS is made of aluminum. Such thermal interface materials are applied to the concerned interlocking arrangements, i.e. SUB_LOCK1 and HS_LOCK in this example. The application is performed as necessary to augment thermal conductivity and to compensate for minor dimensional tolerances, ensuring optimal thermal performance and fit. Cold welding of TIM is possible for instance by indium metal. Therefore, both concerned interlocking arrangements would have to be coated with indium. Cold welding enables low thermal resistance similar to bulk materials.

In the third step CR3(INTER1), the therewith computationally modeled and planned interlocking arrangements SUB_LOCK1 and HS_LOCK are indeed created at the respective surfaces SUB_SURF1, HS_SURF of the substrate SUB and heat sink HS. In concrete, high-precision manufacturing techniques can be employed in step CR3(INTER1) to create the designed interlocking arrangements SUB_LOCK1 and HS_LOCK on the substrate SUB and the heat sink HS surfaces. Techniques such as cold embossing, which allows for tolerances within ±0.05mm, 3D printing, and CNC machining, capable of achieving tolerances around ±0.01mm, ensuring a secure fit and reliable thermal contact are utilized based on the specific requirements. Additionally, laser-assisted machining can improve surface finish and minimize thermal distortion. However, the selection of the manufacturing technique is determined by the required precision and tolerances, respectively, and considerations of manufacturing cost, thus influencing the scalability and feasibility of the process.

Thus, the execution of the procedure steps CR1(INTER1), CR2(INTER1), CR3(INTER1) results in optimized interlocking arrangements SUB_LOCK1 at the surface SUB_SURF1 of the substrate SUB and HS_LOCK and the surface HS_SUFR of the heat sink HS which are adapted to each other. These arrangements are characterized by their tailored geometries, material compatibility, and surface treatments, ensuring both high mechanical stability and optimal thermal performance under operational conditions.

In the same way, the creation procedure PROC_CR(INTER2) including procedure steps CR1(INTER2), CR2(INTER2), CR3(INTER2) is executed for the second interface INTER2, at which the substrate SUB is connected to the semiconductor chip SC, and for the adaption of its interlocking arrangements SUB_LOCK2 and SC_LOCK to each other, resulting in interlocking arrangements SUB_LOCK2 at the surface SUB_SURF2 of the substrate SUB and SC_LOCK and the surface SC_SUFR of the chip SC which are adapted to each other. Therein, specifically regarding the third step CR3(INTER2) of creating the optimized interlocking arrangements SUB_LOCK2 and SC_LOCK on the substrate SUB and the semiconductor chip SC surfaces, Copper (Cu) deposition and sputtering techniques, utilizing masks, can be implemented to construct the requisite interlocking arrangements SUB_LOCK2 and SC_LOCK. The choice among various Cu-sputtering and deposition techniques, including but not limited to Magnetron sputtering, ion-beam sputtering, reactive sputtering, DC sputtering, RF sputtering, or cosputtering, is guided by the required structural height, symmetries, tolerances, and manufacturing cost considerations.

The components COM1=SUB, COM2=HS including the interlocking arrangements ARR1=SUB_LOCK1 and ARR2=HS_LOCK created with the procedure PROC_CR(INTER1) are then securely fixed with each other at the first interface INTER1 with the fixation procedure PROC_FIX(INTER1).

In the first step FIX1(INTER1), the first temperature scenario is induced, e.g. by causing a temperature differential dT(INTER1) across the concerned interlocking arrangements SUB_LOCK1 and HS_LOCK by, for example, either cooling or heating the substrate SUB. At this stage, the components are still separated from each other, as shown in FIG 8. The temperature variance might range from 10°C to 150°C, dependent upon the specific geometry of the structure SUB, its symmetry, and the tolerances inherent in the assembly process. This can be done both under atmospheric or in inert conditions. Additionally or alternatively, the temperature of the heatsink HS surface can be modified to achieve the temperature differential dT(INTER1). For that, the surface HS_SURF of the heatsink HS can be subjected to thermal alteration, either by heating or cooling, to contribute to the establishment of the temperature differential dT(INTER1).

In the second step FIX2(INTER1), the substrate SUB and the heat sink HS are connected with each other by putting their interlocking arrangements SUB_LOCK1, HS_LOCK together as required, as indicated in FIG 9. For example, in case the interlocking arrangements are grooves and ridges, the ridges are precisely positioned in the grooves. Putting together is possible at this stage because of clearances between each two grooves and ridges, as can be seen in FIG 9.

In the third step FIX3(INTER1), the second temperature scenario is induced, e.g. by terminating the temperature differential dT(INTER1). The temperature normalization has an impact on the thermal expansions of the interlocking arrangements SUB_LOCK1, HS_LOCK and results in that the grooves and ridges return to their regular spatial extensions, as indicated in FIG 10, where the clearances shown in FIG 9 have disappeared. This allows for the establishment of contact pressure, culminating in a reliable and enduring connection between the concerned interlocking arrangements, so that the substrate SUB and the heat sink HS are securely fixed to each other.

In case step CR2(INTER1) of PROC_CR(INTER1) has suggested to incorporate a TIM layer between the substrate SUB and the heat sink HS, this TIM layer would be applied as described above at the respective position before execution of the second step FIX2.

Essentially in the same way as PROC_FIX(INTER1), the fixation procedure PROC_FIX(INTER2) including procedure steps FIX1(INTER2), FIX2(INTER2), FIX3(INTER2) is executed for the second interface INTER2, at which the substrate SUB is connected to the semiconductor chip SC, so that the substrate SUB and the semiconductor chip SC are securely fixed to each other.

Regarding the first step FIX1(INTER2) and inducing the first temperature scenario, the substrate SUB and/or the chip SC, featuring copper-sputtered interlocking arrangements, can be pre-tempered. Cooling methods include, but are not limited to, the use of cooling chambers, refrigeration storage, or the application of cold gases such as nitrogen. Heating methods may involve heatable carry trays or the application of voltage through the component. The temperature differential dT(INTER2) to be achieved at the second interface INTER2 might be in a range of 10°C to 150°C. The exact temperature variation is determined based on the geometry, symmetry, and tolerance levels of the components involved. The first step FIX1(INTER2) might include provisions to ensure the temperature of the semiconductor chip SC remains below its critical threshold to avoid damage. Alternatively, or additionally, the surface SUB_SURF2 of the substrate SUB and, therewith, the interlocking arrangement SUB_LOCK2 may undergo thermal modification, either through heating or cooling, to enhance the temperature differential.

In the second step FIX2(INTER2), the semiconductor chip SC and the substrate SUB and, therewith, their concerned interlocking arrangements are SUB_LOCK2, SC_LOCK are aligned and joined. This process leverages the pre-designed interlocking structures on the components, ensuring a secure and precision-aligned assembly. This step is vital for maintaining the functional integrity of the electronic device 100.

In the third step FIX3(INTER2), the second temperature scenario is induced, e.g. by terminating the temperature differential dT(INTER2), i.e. temperatures modified in step FIX1(INTER2) are allowed to return to the regular temperature range TR. This normalization allows for the establishment of contact pressure, culminating in a reliable and enduring connection between the concerned interlocking arrangements of INTER2, so that the substrate SUB and the semiconductor chip SC are securely fixed to each other. The temperature normalization has an impact on the thermal expansions of the interlocking arrangements SUB_LOCK1, HS_LOCK and results in that the grooves and ridges return to their regular spatial extensions, as indicated in FIG 10, where the clearances shown in FIG 9 have disappeared. This step typically requires gradual temperature stabilization to prevent thermal shock or residual stresses that could weaken the connection. For instance, cooling or heating rates can be controlled to 1-5°C/min depending on the material's thermal conductivity and specific heat capacity.

The creation and fixation procedures might be executed in a sequence PROC_CR(INTER1), PROC_CR(INTER2), PROC_FIX(INTER1), PROC_FIX(INTER2) or, alternatively in a sequence PROC_CR(INTER1), PROC_FIX(INTER1), PROC_CR(INTER2), PROC_FIX(INTER2).

A second embodiment concerns mounting sensors or, as a concrete example, Microelectromechanical Systems (MEMS). Herein, the electronic device 100 comprises a MEMS and a printed circuit board PCB, wherein the MEMS shall be mounted on the board PCB.

Like in the first embodiment, it is again desired to securely fix the MEMS and the board PSB with each other, such that such connection can be loosened again to address 7R and 3R requirements, as described above. For that purpose, both the MEMS and the board PCB shall be equipped with an interlocking arrangement MEMS_LOCK, PCB_LOCK as introduced above at its respective surfaces MEMS_SURF, PCB_SURF which are facing each other when MEMS and PCB are connected to each other.

In concrete, the interlocking arrangement MEMS_LOCK, PCB_LOCK form the interface INTER. Thus, it is required that the interlocking arrangements MEMS_LOCK, PCB_LOCK of the interface INTER are "adapted to each other" so that they are suitable for the shrink fitting procedure. This requirement can be fulfilled by executing the procedure PROC_CR(INTER) for the interface INTER, i.e. for the interlocking arrangements ARR1=MEMS_LOCK and ARR2=PCB_LOCK.

For the interface INTER, at which the MEMS is connected to the board PCB, and for the adaption of its interlocking arrangements MEMS_LOCK and PCB_LOCK to each other, the first procedure step CR1(INTER) of the procedure PROC_CR(INTER) is executed, including the selection of suitable geometries of the interlocking arrangements MEMS_LOCK and PCB_LOCK, e.g. grooves and ridges.

In the second step CR2(INTER), a computational modelling is employed for design and subsequent design optimization of the interlocking arrangements MEMS_LOCK and PCB_LOCK, e.g. to determine the depths and widths of the grooves and ridges as well as the best suited materials.

In the third step CR3(INTER), the therewith computationally modeled and planned interlocking arrangements MEMS_LOCK and PCB_LOCK are indeed created at the respective surfaces MEMS_SURF, PCB_SURF of the MEMS and board PCB. In concrete, step CR3(INTER) might apply Cu-sputtering techniques with masks to create the interlocking arrangements MEMS_LOCK and PCB_LOCK on the mating surfaces of the MEMS and the board PCB. The selection of the specific Cu-sputtering technique is dependent upon the desired structural height and precision and tolerances, respectively, as well as the associated manufacturing costs.

Thus, the execution of the procedure steps CR1(INTER), CR2(INTER), CR3(INTER) results in optimized interlocking arrangements MEMS_LOCK at the surface MEMS_SURF of the MEMS and PCB_LOCK and the surface PCB_SURF of the printed circuit board PCB which are adapted to each other.

The components COM1=MEMS, COM2=PCB including the interlocking arrangements ARR1=MEMS_LOCK and ARR2=PCB_LOCK created with the procedure PROC_CR(INTER) are then securely fixed to each other with the fixation procedure PROC_FIX(INTER).

In the first step FIX1 (INTER), the first temperature scenario is induced, e.g. by generating the temperature differential dT(INTER) across the concerned interlocking arrangements MEMS_LOCK and PCB_LOCK by, for example, pre-tempering the MEMS and/or the board PCB. Suitable cooling methods might include, but are not limited to, the use of cooling chambers, refrigeration storage, or the application of cold gases such as nitrogen. Heating methods may involve heatable carry trays or the application of voltage through the component. The temperature differential dT(INTER) to be achieved in this embodiment might be within a range of 10°C to 150°C, depending on the geometry, symmetry, and tolerance levels of the concerned interlocking arrangements MEMS_LOCK and PCB_LOCK. The procedure might include provisions to ensure the temperature of the MEMS remains below its critical threshold to avoid damage.

In the second step FIX2(INTER), the MEMS and the board PCB are connected with each other by putting their interlocking arrangements MEMS_LOCK, PCB_LOCK together as required. For example, in case the interlocking arrangements are grooves and ridges, the ridges are positioned in the grooves.

In the third step FIX3(INTER), the second temperature scenario is induced, e.g. by terminating the temperature differential dT(INTER), i.e. temperatures of the board PCB and/or the MEMS modified in step FIX1 (INTER) are allowed to return to the regular temperature range TR. This normalization allows for the establishment of contact pressure, culminating in a reliable and enduring connection between the concerned interlocking arrangements, so that the MEMS and the board PCB are securely fixed to each other.

Although specific embodiments have been illustrated and described herein, it will be appreciated by those of ordinary skill in the art that a variety of alternate and/or equivalent implementations exists. It should be appreciated that the exemplary embodiments are only a few examples with illustrative character which are not intended to limit or restrict the scope, applicability, or configuration in any way. Rather, the foregoing summary and detailed description will provide those skilled in the art with a convenient road map for implementing at least an embodiment, it being understood that various changes may be made in the function and arrangement of elements described in an exemplary embodiment without departing from the scope as set forth in the appended claims and their legal equivalents. Generally, this application is intended to cover any adaptations or variations of the specific embodiments discussed herein.

## Claims

1. Method METH_CR_FIX(INTER) for connecting a first COM1 and a second component COM2 of an electronic device with each other at an interface INTER by securely fixing a first interlocking arrangement ARR1 of the first component COM1 to a second interlocking arrangement ARR2 of the second component COM2 and with the help of applying different temperature scenarios such that
- the interlocking arrangements ARR1, ARR2 of the components COM1, COM2 and, therewith, the components COM1, COM2 themselves are securely fixed to each other under a second one of the temperature scenarios and
- the interlocking arrangements ARR1, ARR2 of the components COM1, COM2 are attachable to each other and, in case previously securely fixed to each other, non-destructively separable from each other and under a first one of the temperature scenarios,
wherein the method METH_CR_FIX(INTER) applies a shrink fitting procedure to connect the first COM1 and the second component COM2.

2. Method METH_CR_FIX(INTER) according to claim 1, wherein the interface INTER comprises the interlocking arrangements ARR1, ARR2, wherein
- the first temperature scenario is **characterized in that** a temperature differential dT across the interface INTER and, therewith, between the interlocking arrangements ARR1, ARR2 is above a given threshold or that the temperature of the interface INTER and its interlocking arrangements ARR1, ARR2, respectively, is outside a given regular operation temperature range TR of the electronic device,
- the second temperature scenario is **characterized in that** the temperature differential dT across the interface INTER and, therewith, between the interlocking arrangements ARR1, ARR2 is below a given threshold or that the temperature of the interface INTER and its interlocking arrangements ARR1, ARR2, respectively, is within the given regular temperature range TR of the electronic device during regular operation of the device.

3. Method METH_CR_FIX(INTER) according to any one of claims 1 to 2, wherein an interlocking arrangement ARR1 of the first component COM1 and an interlocking arrangement ARR2 of the second component COM2 are created in a creation procedure PROC_CR(INTER) of the method METH_CR_FIX(INTER) at respective surfaces SURF1, SURF2 of the components COM1, COM2 such that the interlocking arrangements ARR1, ARR2 are adapted to each other for the purpose of connecting the components COM1, COM2 with each other with the shrink fitting procedure.

4. Method METH_CR_FIX(INTER) according to claim 3, wherein the creation procedure PROC_CR(INTER) comprises
- a first step CR1(INTER) of selecting geometries of the interlocking arrangements ARR1 and ARR2 suitable for the shrink fitting procedure,
- a second step CR2(INTER) of employing a computational modelling for designing and design optimization of the interlocking arrangements ARR1 and ARR2 based on the selected geometries and/or for selecting materials for the interlocking arrangements ARR1 and ARR2,
- a third step CR3(INTER) of producing the computationally modeled interlocking arrangements ARR1, ARR2 at the respective surfaces COM1_SURF, COM2_SURF of the components COM1, COM2.

5. Method METH_CR_FIX(INTER) according to any one of claims 3 to 4, wherein the interlocking arrangements ARR1, ARR2 of the components COM1, COM2 are securely fixed to each other in a fixation procedure PROC_FIX(INTER) of the method METH_CR_FIX(INTER) for the purpose of connecting the components COM 1, COM2 with each other with the shrink fitting procedure.

6. Method METH_CR_FIX(INTER) according to claim 5, wherein the fixation procedure PROC_FIX(INTER) comprises
- a first step FIX1(INTER) of changing the temperature of at least one of the interlocking arrangements ARR1, ARR2 such that the first temperature scenario is induced,
- a second step FIX2(INTER) of connecting the components COM1, COM2 with each other by putting their interlocking arrangements ARR1, ARR2 together such that they interlock,
- a third step FIX3(INTER) of actively or passively changing the temperature of at least one of the interlocking arrangements ARR1, ARR2 such that the second temperature scenario is induced.

7. Method METH_CR_FIX(INTER) according to any one of claims 1 to 6, wherein a comprehensive documentation DOCASS(INTER) about the applied parameters of the creation procedure PROC_CR(INTER) and the fixation procedure PROC_FIX(INTER) is generated, wherein the documentation DOCASS(INTER) and the parameters, respectively, includes information required for later separation of the components COM1, COM2 for disassembly of the electronic device.

8. Method METH_CR_FIX(INTER) according to any one of claims 1 to 7, wherein the electronic device is a MEMS module comprising a MEMS as the first component COM1=MEMS and a printed circuit board PCB as the second component COM2=PCB.

9. Method METH_CR_FIX(INTER) according to any one of claims 1 to 7, wherein the electronic device is a power electronic module comprising a heat sink HS, a substrate SUB, and a semiconductor chip SC, wherein
- the substrate SUB is the first component COM1=SUB and the heat sink HS is the second component COM2=HS and/or
- the substrate SUB is the first component COM1=SUB and the semiconductor chip SC is the second component COM2=SC.

10. Disassembly method METH_DISASS(INTER) for separating components COM1, COM2 of an electric device which have been securely fixed to each other at the interface INTER based on a shrink fitting procedure, preferably based on the method METH_CR_FIX(INTER) according to any one of claims 1 to 9, wherein
- in a first step DIS1(INTER) of the disassembly method METH_DISASS(INTER), the first temperature scenario is induced at the interface INTER,
- in a second step DIS2(INTER) of the disassembly method METH_DISASS(INTER), the components COM1, COM2 are separated from each other once the conditions conducive to disengagement of COM1 and COM2 are established.

11. Disassembly method METH_DISASS(INTER) according to claim 10 and claim 7, wherein the required temperature generated under the first temperature scenario in step DIS1(INTER) and/or the required forces and directions for separating the components COM1, COM2 are set based on the documentation DOCASS(INTER) of the Method METH_CR_FIX(INTER).

12. Electronic device, manufactured or assembled, respectively, with a method according to any one of claims 1 to 9, **characterized in that** the device comprises at least two components COM1, COM2, wherein
- each one of the components COM1, COM2 comprises at least one interlocking arrangement ARR1, ARR2,
- the components COM1, COM2 are securely fixed to each other with the help of their interlocking arrangements ARR1, ARR2 based on the shrink fitting procedure when the electronic device is in the assembled state.

13. Electronic device according to claim 12, wherein the electronic device is a MEMS module comprising a MEMS and a printed circuit board PCB, wherein the MEMS and the printed circuit board PCB are securely fixed to each other at the interface INTER based on the shrink fitting procedure when the MEMS module is in the assembled state.

14. Electronic device according to claim 12, wherein the electronic device is a power module comprising a heat sink HS, a substrate SUB, and a semiconductor chip SC, wherein both the heat sink HS and the semiconductor chip SC are each securely fixed to the substrate SUB based on the shrink fitting procedure when the power module is in the assembled state.
